# EUROPEAN PATENT SPECIFICATION

(11) **EP 1 458 520 B1**
(45) Date of publication and mention of the grant of the patent: **14.02.2007**
(21) Application number: 02787052.6
(22) Date of filing: 17.12.2002
(51) Int. Cl.: B24B 7/22, B24D 3/00, B24B 37/04

(54) **METHODS FOR PLANARIZATION OF GROUP VIII METAL-CONTAINING SURFACES USING A FIXED ABRASIVE ARTICLE**
VERFAHREN ZUR PLANARISIERUNG VON OBERFLÄCHEN, DIE METALLE DER GRUPPE VIII ENTHALTEN, UNTER VERWENDUNG EINES FIXIERTEN SCHLEIFGEGENSTANDS
PROCEDES DE PLANARISATION DE SURFACES CONTENANT UN METAL DU GROUPE VIII AU MOYEN D'UN ARTICLE ABRASIF FIXE

(30) Priority: 21.12.2001 US 28616
(43) Date of publication of application: 22.09.2004
(73) Proprietor: MICRON TECHNOLOGY, INC., Boise, ID 83707-0006 (US)
(72) Inventor: SABDE, Gundu, M., Boise, ID 83716 (US)
(74) Representative: Vossius & Partner
(86) International application number: PCT/US2002/040406
(87) International publication number: WO 2003/059571

(56) References cited:
- WO-A-01/44396
- US-A- 5 692 950
- US-A- 5 958 794
- US-B1- 6 306 012

## Description

The present invention relates to methods for planarization of Group VIII metal-containing (preferably, platinum-containing) surfaces, particularly in the fabrication of semiconductor devices.

During fabrication of semiconductor devices, various surfaces are formed. Many of such surfaces do not have uniform height, and therefore, the wafer thickness is also non-uniform. Further, surfaces may have defects such as crystal lattice damage, scratches, roughness, or embedded particles of dirt or dust. For various fabrication processes to be performed, such as lithography and etching, height non-uniformities and defects at the surface of the wafer must be reduced or eliminated. Various planarization techniques are available to provide such reduction and/or elimination. One such planarization technique includes mechanical and/or chemical-mechanical polishing (abbreviated herein as "CMP").

The process of planarization is used to remove material, and preferably achieve a planar surface, over the entire chip and wafer, sometimes referred to as "global planarity." Conventionally, the process of planarization, and particularly CMP, involves the use of a wafer carrier that holds a wafer, a polishing pad, and an abrasive slurry that includes a dispersion of a plurality of abrasive particles in a liquid. The abrasive slurry is applied so that it contacts the interface of the wafer and the polishing pad. A table or platen has a polishing pad thereon. The polishing pad is applied to the wafer at a certain pressure to perform the planarization, At least one of the wafer and a polishing pad are set in motion relative to the other. In some planarization processes, the wafer carrier may or may not rotate, the table or platen may or may not rotate and/or the platen may be moved in a linear motion as opposed to rotating. There are numerous types of planarization units available which perform the process in different manners.

The use of abrasive slurries in wafer fabrication has proven problematic for several reasons. First, abrasive slurries that contain a plurality of abrasive particles in a dispersion tend to be unstable. In particular, not only do the abrasive particles settle, the abrasive particles also tend to agglomerate, both phenomenon resulting in a nonuniform slurry composition. This, in turn, creates wide variability in the polishing results. Second, it is known within the art that the composition of the slurry tends to be very specific with the desired planarization process, i.e., one slurry may not be suitable for a variety of processes.

Also, conventional polishing pads pose planarization difficulties. Such pads may glaze, or become embedded with debris, during planarizing. This requires the pads to be conditioned such that the pads can be reused. Conditioning typically involves removal of the debris from the polishing pad using mechanical means with or without application of a solution. Conditioned pads typically lead to subsequent unpredictable planarization results because of the unpredictability in removal of debris from the pad itself during conditioning.

Fixed abrasive articles used in place of conventional polishing pads are also known and used in planarization processes. Such fixed abrasive articles include a plurality of abrasive particles dispersed within a binder adhered to at least one surface of a backing material. For certain situations, fixed abrasive articles are advantageous; however, conventional abrasive slurries are typically incompatible with fixed abrasive articles for many planarization processes.

The planarization of a surface that includes platinum and other Group VIII metals typically involves more mechanical than chemical action during a polishing process because they are relatively chemically inert and/or have relatively few volatile produces. Such mechanical polishing uses alumina and silica particles , see, for example, WO 01/44396 A1. Unfortunately, mechanical polishing tends to cause the formation of defects (e.g., scratches and particles), both of which can be detected optically, rather than the clean removal of the platinum.

Thus, there is still a need for methods for planarizing an exposed surface of a substrate that includes platinum and other Group VIII metals, particularly in the fabrication of semiconductor devices.

The present invention provides methods that overcome many of the problems associated with the planarization of a surface that includes platinum and/or another of the Group VIII second and third row metals (i.e., Groups 8, 9, and 10, preferably, Rh, Ru, Ir, Pd, and Pt). Such a surface is referred to herein as a platinum-containing surface, or more generally, a Group VIII metal-containing surface. A "Group VIII metal-containing surface" refers to an exposed region having a Group VIII metal (particularly, platinum) preferably present in an amount of at least about 10 atomic percent, more preferably at least about 20 atomic percent, and most preferably at least about 50 atomic percent, of the composition of the region, which may be provided as a layer, film, coating, etc., to be planarized (e.g., via chemical-mechanical or mechanical planarization or polishing) in accordance with the present invention. The surface preferably includes (and more preferably, consists essentially of) one or more Group VIII metals in elemental form or an alloy thereof (with each other and/or one or more other metals of the Periodic Table). That is, the surface does not include significant amounts of nonmetals such as silicon or oxygen atoms, as occur in a silicide or oxide.

The methods of the present invention involve planarizing a surface. Herein, as is conventionally understood, "planarizing" or "planarization" refers to the removal of material from a surface, whether it be a large or small amount of material, either mechanically, chemically, or both. This also includes removing material by polishing. As used herein, "chemical-mechanical polishing" and "CMP'' refer to a dual mechanism having both a chemical component and a mechanical component, wherein corrosion chemistry and fracture mechanics both play a roll in the removal of material, as in wafer polishing.

In one aspect of the present invention, a planarization method according to claim 1 is provided that includes: positioning a Group VIII metal-containing surface of a substrate (preferably, a semiconductor substrate or substrate assembly such as a wafer) to interface with a fixed abrasive article; supplying a planarization composition in proximity to the interface, wherein the planarization composition comprises an oxidizing agent, a complexing agent, or mixtures thereof and wherein the planarization composition has a pH of about 1.5 to about 3 and planarizing the Group VIII metal-containing surface using the fixed abrasive article. The Group VIII metal is selected from the group consisting of rhodium, iridium, ruthenium, osmium, palladium, platinum, and combinations thereof. The fixed abrasive article includes a plurality of abrasive particles having a hardness of no greater than about 6.5 Mohs dispersed within a binder adhered to at least one surface of a backing material.

As used herein, "semiconductor substrate or substrate assembly" refers to a semiconductor substrate such as a base semiconductor layer or a semiconductor substrate having one or more layers, structures, or regions formed thereon. A base semiconductor layer is typically the lowest layer of silicon material on a wafer or a silicon layer deposited on another material, such as silicon on sapphire. When reference is made to a substrate assembly, various process steps may have been previously used to form or define regions, junctions, various structures or features, and openings such as vias, contact openings, high aspect ratio openings, conductive regions, contact regions, etc. For example, a substrate assembly may refer to a structure upon which a metallization is to be performed, e.g., metal lines are formed for electrical interconnection functionality.

Preferred embodiments of the present invention are summarized in method claims 2 to 19.

In any of the methods in accordance with the present invention, the fixed abrasive article preferably includes a plurality of abrasive particles such as CeO₂ particles, Y₂O₃ particles, Fe₂O₃ particles, or mixtures thereof. More preferably, a majority of the plurality of abrasive particles are CeO₂ abrasive particles.

In any of the methods in accordance with the present invention, the planarization composition does not typically include abrasive particles.
Figure 1A and 1B are cross-sectional illustrations of one portion of a wafer before and after a planarization process has been performed in accordance with the present invention;
Figures 2A and 2B are cross-sectional illustrations of one portion of a wafer before and after a planarization process has been performed in accordance with the present invention;
Figure 3 is a general diagrammatical illustration of a chemical-mechanical polishing system utilized in accordance with the present invention;
Figure 4 is an enlarged cross-sectional view taken across line A-A of Figure 3; and
Figure 5 is a schematic of one operation of a process in accordance with the present invention.

According to claim 1 the present invention provides methods of planarization of a surface that includes platinum and/or one or more of the other second or third row Group VIII metals. The Group VIII metals are also referred to as the Group VIIIB elements or transition metals of Groups 8, 9, and 10 of the Periodic Table. The second and third row Group VIIIB metals include Rh, Rn, Ir, Pd, Pt, and Os. Preferably, surfaces that include Rh, Ru, Ir, Pd, and/or Pt can be planarized according to methods of the present invention. Such a surface is referred to herein as a Group VIII metal-containing surface (this refers to those containing second and/or third row transition metals).

Preferably, a "Group VIII metal-containing surface" refers to an exposed region having a Group VIII metal (particularly, platinum) present in an amount of at least about 10 atomic percent, more preferably at least about 20 atomic percent, and most preferably at least about 50 atomic percent, of the composition of the region, which may be provided as a layer, film, coating, etc., to be planarized (e.g., via chemical-mechanical or mechanical planarization or polishing) in accordance with the present invention.

The planarization of such surfaces, particularly a surface that includes platinum, typically involves mechanical methods with relatively hard particles such as alumina. (Al₂O₃) and silica (SiO₂) particles, which can cause smearing and the formation of defects rather than the clean removal of the material. Surprisingly, the use of a fixed abrasive article that includes abrasive particles having a hardness of no greater than about 6.5 Mohs reduces, and often eliminates, the problems of smearing and defect formation. Such particles include, for example, ceria (CeO₂), which has a hardness of about 6.0 Mohs, as well as yttrium oxide (Y₂O₃), which has a hardness of about 5.5 Mohs, and ferric oxide (Fe₂O₃), which has a hardness of about 6.0 Mohs. This is in contrast to alumina abrasive particles, which have a hardness ranging from about 8.5 Mohs to about 9.0 Mohs, and silica abrasive particles, which have a hardness ranging from about 7.5 Mohs.

Fixed abrasive articles that include a plurality of abrasive particles having a hardness of no greater than about 6.5 Mohs are used with a planarization composition, and thus, in a variety of planarization processes, including mechanical or chemical-mechanical. In any of the methods in accordance with the present invention, the fixed abrasive preferably includes a plurality of CeO₂ particles, Y₂O₃, Fe₂O₃, or mixtures thereof. More preferably, a majority of the plurality of abrasive particles are CeO₂ particles.

Typically, the abrasive particles range in particle size (i.e., the largest dimension of the particle) on average from about 10 nanometers (nm) to about 5000 nm, and more often about 30 nm to about 1000 nm. For preferred embodiments, suitable abrasive particles have an average particle size of about 100 nm to about 300 nm.

Significantly, the methods of the present invention are particularly advantageous in planarizing a surface that includes a "nonplanar" (i.e., "nonflat") topography, i.e., a surface that includes regions of greater height than other regions of the surface. Examples of surfaces that have a nonplanar topography include those that have undulating layers or those with structures such as in capacitors. Typically, "nonplanar" (i.e., "nonflat") surfaces have regions that are at least about 200 Angstroms higher, preferably, at least about 500 Angstroms higher, and more preferably, at least about 2000 Angstroms higher, than other regions of the surface. The fixed abrasive articles used in the methods of the present invention contribute to a higher rate of removal of material from surfaces having a nonplanar topography when compared to surfaces that are planar or flat (e.g., a blanket layer in a semiconductor substrate assembly, or other surfaces having regions that are less than about 200 Angstroms in height differential). Preferably, the rate of removal of material from a surface that has a nonplanar topography is at least about 10 times, and often as much as about 25 times, that of the rate of removal of material from a generally planar or flat surface.

Significantly, the methods of the present invention are particularly advantageous in removing platinum or other Group VIII metals from a surface in preference to other materials, particularly silicon dioxide. This is important in selectively removing material from platinum-containing or other Group VIII metal-containing layers without removing, for example, significant amounts of underlying layers, such as oxide layers (e.g., TEOS orBPSG layers). Preferably, the selectivity for removal of material from a Group VIII metal-containing surface having a nonplanar topography, wherein the Group VIII metal is in elemental form (including alloys), relative to material from a dielectric layer (e.g., silicon dioxide, silicon nitride, BPSG) is within a range of about 10:1 to about 25: 1, depending on the chemistry and process conditions. This selectivity ratio can be increased even further with the use of planarization compositions including one or more oxidizing agents and or complexing agents, for example. By comparison, the selectivity for removal of material from a Group VIII metal-containing planar (i.e., flat) surface relative to material from an oxide-containing surface is about 1:1, using the same fixed abrasive article and process conditions.

For enhancing selectivity, a planarization composition is used in the methods of the present invention. A suitable composition includes an oxidizing agent and/or complexing agent (more preferably an oxidizing agent) to aid in the planarization, as well as other additives such as a surfactant to enhance wettability and reduce friction, a thickener to achieve a desired viscosity, a buffering agent to achieve a desired pH, etc. Preferably, the composition is an aqueous solution of these components. The planarization composition has a pH of about 1.5 to about 3. Preferred oxidizing agents (i.e., oxidants) include, for example, ceric ammonium nitrate, ceric ammonium sulfate, etc. Examples of suitable planarization compositions are disclosed in Applicant's Assignee's copending U.S. Patent Applications: Serial Number 10/028,249, Publication No. US 20030119316 A1, filed on December 21, 2001, entitled METHODS FOR PLANARIZATION OF GROUP VIII METAL-CONTAINING SURFACES USING OXIDIZING AGENTS; Serial Number 10/028,040, Publication No. US 20030119319 A1, filed on December 21, 2001 entitled METHODS FOR PLANARIZATION OF GROUP VIII METAL-CONTAINING SURFACES USING COMPLEXING AGENTS; and Serial Number 10/032,357, Publication No. US 20030.119321 A1, filed on December 21,2001 entitled METHODS FOR PLANARIZATION OF GROUP VIII METAL-CONTAINING SURFACES USING OXIDIZING GASES.

It is to be understood that a planarization composition suitable for use in the methods of the present invention is preferably essentially free of abrasive particles when supplied to the interface of the fixed abrasive article and the workpiece surface. However, it is contemplated that planarization is accomplished by one or both of the fixed abrasive article and/or abrasive particles that may be removed from the fixed abrasive article at the fixed abrasive/surface interface in combination with the planarization composition. In any event, abrasive particles are typically not present in the composition as initially applied, i.e., they are not supplied from a source external to the polishing interface.

A suitable fixed abrasive for use in the present invention is known, such as that described in U.S. Patent No. 5,692,950 (Rutherford, et al.) and International Patent Publication WO 98/06541. In general, a fixed abrasive includes a plurality of abrasive particles dispersed within a binder that forms a three-dimensional fixed abrasive element that is adhered to one surface of a backing material. Commercially available fixed abrasive articles can be obtained from Tokyo Sumitsu Kageki and Ebera Corporation, both of Japan, and Minnesota Mining and Manufacturing Company (3M Company) of St. Paul, MN. An example of a preferred fixed abrasive article is a ceria-based pad commercially available from 3M Company under the trade designation "SWR 159."

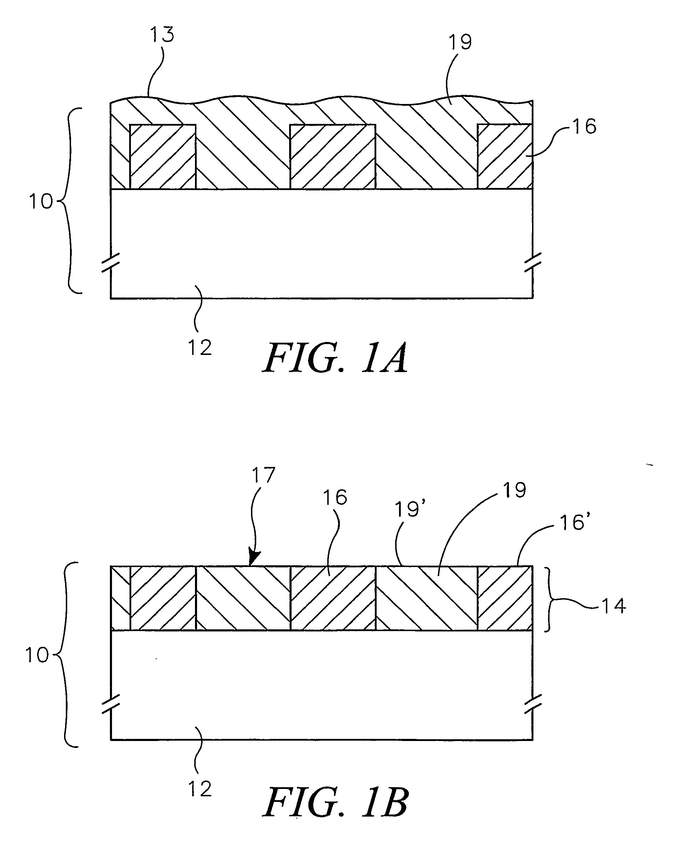

The figures provide further information about the methods of the invention. Figure 1A illustrates one portion of a wafer 10 prior to planarization in accordance with the present invention having features that are filled with the material to be removed through planarization. The wafer portion 10 includes a substrate assembly 12 having junctions 16 formed thereon. A capacitor and/or barrier layer material 19 is then formed over the substrate assembly 12 and the junctions 16. The capacitor and/or barrier layer material 19 may be any conductive material such as platinum or any other suitable conductive second or third row Group VIII metal-containing capacitor and/or barrier material. Generally, as shown in Figure 1A, the nonplanar upper surface 13 of capacitor and/or barrier layer 19 is subjected to planarization or other processing in accordance with the present invention. The resulting wafer 10, which is shown in Figure 1B, includes an upper surface 17 planarized such that the thickness of the wafer 10 is substantially uniform across the entire wafer 10 so that the wafer now includes a capacitor and/or barrier structure layer 14.

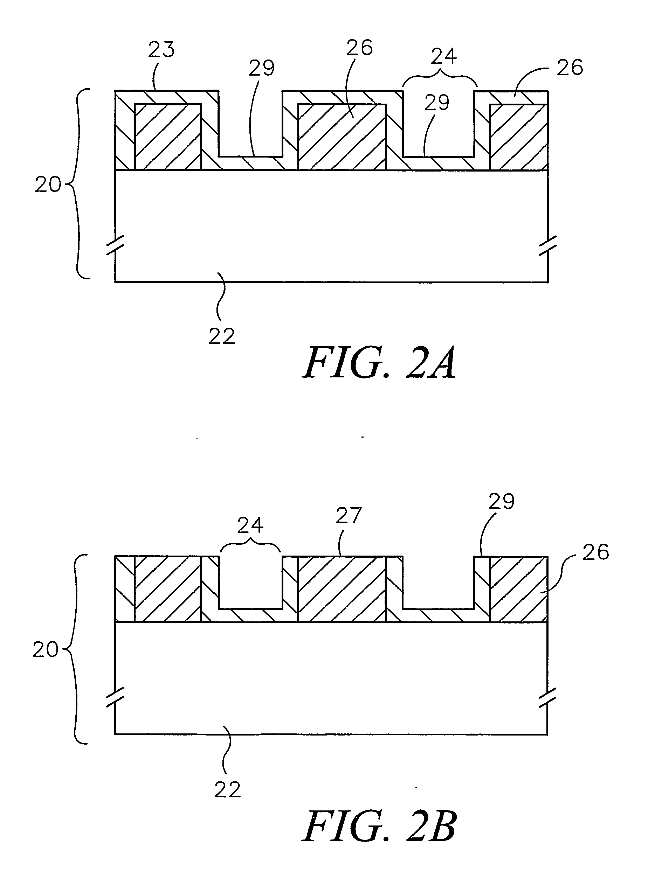

Figure 2A illustrates one portion of a wafer 20 prior to planarization in accordance with the present invention having features that have a conformal layer of the material to be removed through planarization. The wafer portion 20 includes a substrate assembly 22 having a patterned dielectric layer 26 formed thereon. Such a patterned dielectric layer 26 can be used in a variety of structures, particularly a capacitor structure. The patterned dielectric layer 26 can be formed of any material that provides electrical isolation between metal regions (e.g., silicon dioxide, silicon nitride, or BPSG). An electrode layer 29 is then formed over the substrate assembly 22 and the patterned dielectric layer 26. The electrode layer 29 may be platinum or any other suitable conductive second or third row Group VIIIB or Group IB metal-containing material. Generally, as shown in Figure 2A, the nonplanar upper surface 23 of electrode layer 29 is subjected to planarization or other processing in accordance with the present invention. The resulting wafer 20, as shown in Figure 2B, includes an upper surface 27 planarized such that the thickness of the wafer 20 is substantially uniform across the entire wafer 20 so that the wafer now includes electrically conducting regions 24 isolated within the patterned dielectric material 26 forming a capacitor structure. If desired, prior to planarization, the conformal layer 29 and openings 24 can be covered with a photoresist or other material that is removed after the planarization so the abrasive does not fall into the openings 24.

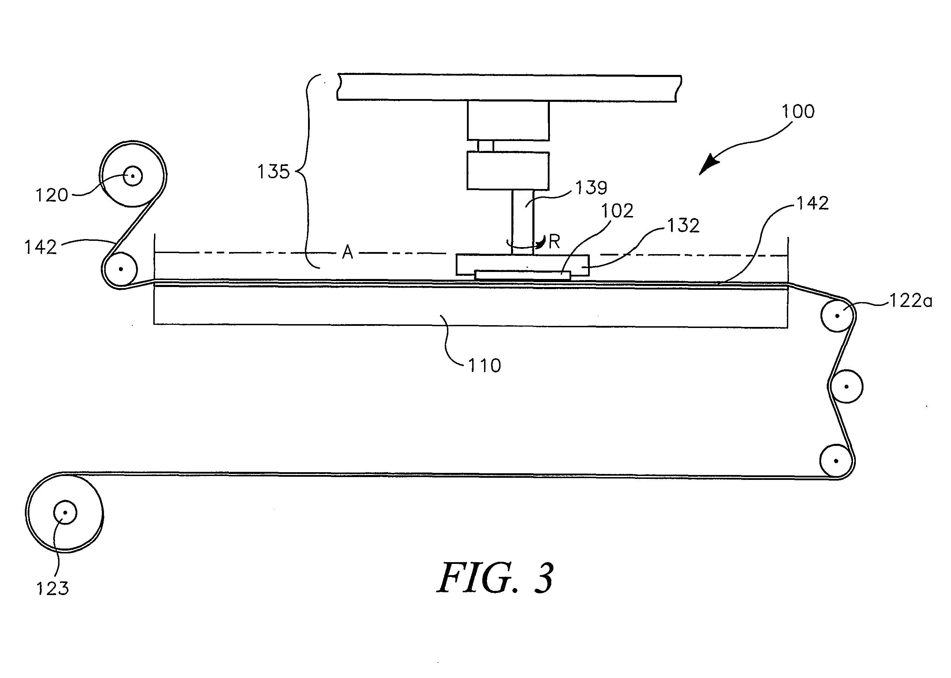

One generally illustrated planarization assembly 100, as shown in Figure 3, includes a revolving wafer carrier platform 135 that holds wafer 102 of which wafer portion 10 (shown in Figures 1A and 1B) is a part thereof. A planarization composition is typcially introduced at or near the interface between the fixed abrasive article 142 and the wafer 102. A fixed abrasive article 142 is then supplied between a platen 110 and the wafer 102.

As shown in Figure 3, the fixed abrasive article 142 may be supplied in a continuous manner, wherein a supply roll 120 feeds an elongated fixed abrasive article 142 to a polishing interface between the platen 110 and the wafer 102. After the polishing life of a portion of the fixed abrasive article 142 has been exhausted, the fixed abrasive article 142 can be advanced and is wound up on a take-up roll 123. Alternatively, a fixed abrasive article of a defined size may be attached to the platen 110 for use in a discrete manner, i.e., not continuous.

Optionally, a station (not shown) may be provided that can serve to pre-wet the fixed abrasive article prior to planarization or it can serve to flush the fixed abrasive article between the planarization of different wafers. The fixed abrasive article 142 can be advanced to the station, located in close proximity to a rotating drum 122a, and a solution provided to the station and applied, such as by drip, spray, or other dispensing means, to the fixed abrasive surface that will ultimately contact the wafer. More preferably, the solution is an aqueous solution and, even more preferably, the solution is water or a planarization composition in accordance with the present invention. After application of the solution, the fixed abrasive article 142 is then positioned to contact the surface of the wafer for planarization.

The fixed abrasive article 142 contacts a surface of the wafer 102 (e.g., the surface 13 of wafer 10 as depicted in Figure 1A) in the presence of a planarization composition during the planarization process. Pressure can be applied, typically by a downward force applied to a carrier arm 139 affixed the holder 132, although a backside pressure can be applied from a platen 110 is contemplated by the present invention. Preferably, a method in accordance with the present invention is conducted at atmospheric pressure and at a temperature in a range from about 4°C to about 62°C. In one embodiment, both a wafer holder 132 and/or the platen 110 can be revolved and moved by motors or drive means (not shown) as is readily known to those skilled in the art.

Wafer holder 132 revolves wafer 102 at a selected velocity in a circular direction indicated by arrow "R" and moves wafer 102 under controlled pressure across a portion of the fixed abrasive article 142. The wafer 102 contacts the fixed abrasive article 142 as it is moved. The area of the fixed abrasive article 142 which comes into contact with the surface of the wafer 102 varies as the wafer 102 is moved as is known to those skilled in the art. For example, the fixed abrasive article 142 can be moved a distance that is less than a maximum diameter of a wafer such that a subsequently polished wafer is exposed to a second position on the fixed abrasive. Preferably, the second position on the fixed abrasive includes at least a portion that was not utilized to polish the wafer immediately preceding it. Thus, all or a portion of the second position on the fixed abrasive can include a portion that was not utilized to polish the wafer immediately preceding it. One suitable distance that the fixed abrasive article 142 can be moved is less than about 1.0% of the maximum diameter of the wafer. Thus, for a wafer having a maximum diameter of about 8 inches (about 20.3 cm), a distance that the fixed abrasive article 142 can be, moved is about 0.25 inch (about 0.64 cm). Another suitable distance that the fixed abrasive article 142 can be moved is a distance substantially equal to the maximum diameter of the wafer.

A supply system (not shown) introduces a planarization composition atop the fixed abrasive article 142, preferably at or near the interface or contact area between the surface of the wafer 102 and the fixed abrasive article 142 at a specified flow rate. The planarization composition may be introduced at various locations about the fixed abrasive. For example, the planarization composition may be introduced from above the fixed abrasive article 142, such as by drip, spray, or other dispensing means.

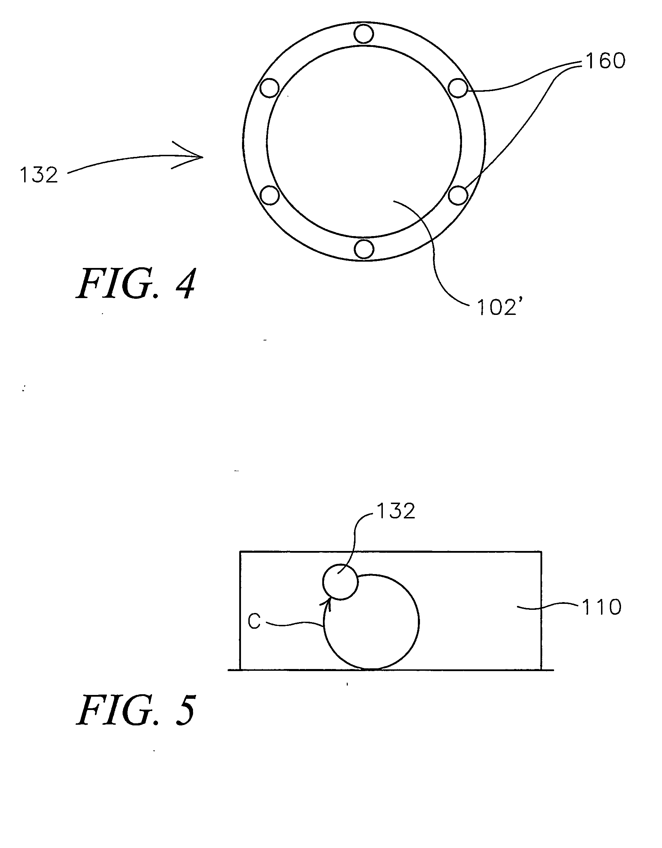

As shown in Figure 4, taken across line A-A in Figure 3, the composition may be introduced at or near the wafer/fixed abrasive article interface by supplying the composition to a dispensing mechanism directly incorporated in the wafer holder 132 of the wafer carrier platform 135. A plurality of supply ports 160 are arranged around the periphery of the wafer holder 132 through which the composition can be dispensed. The composition can be dispensed through all or a few of the supply ports at any given time during the planarization process. As shown in Figure 4, one preferred arrangement of the plurality of supply ports 160 is about the circumference of a wafer attachment portion 102' of the wafer holder 132, although other arrangements are possible.

The wafer holder 132 is preferably revolved at a speed of about 200-600 millimeters per second. As shown in Figure 5, the wafer holder 132 preferably revolves in a path designated by arrow "C" in contact with the platen 110 including the fixed abrasive article 142. The speed of the wafer holder 132 is then related to the length of "C." The surface of the wafer 102 is held in juxtaposition relative to the fixed abrasive article 142 so that the fixed abrasive article 142 can planarize the surface.

Although the foregoing has been described with particular attention to a revolving wafer holder, it is to be understood that for planarization both the wafer holder and the platen can move relative to one another. For example, the wafer holder can revolve/rotate and the platen can revolve or orbit. Further, either the wafer holder or the platen can be stationary.

The foregoing detailed description has been given for clarity of understanding only. No unnecessary limitations are to be understood therefrom. The invention is not limited to the exact details shown and described, for variations obvious to one skilled in the art will be included within the invention defined by the claims.

## Claims

1. A planarization method comprising:
positioning a Group VIII metal-containing surface of a substrate to interface with a fixed abrasive article, wherein the Group VIII metal is selected from the group consisting of rhodium, iridium, ruthenium, osmium, palladium, platinum, and combinations thereof;
supplying a planarization composition in proximity to the interface wherein the planarization composition comprises an oxidizing agent, a complexing agent, or mixtures thereof and wherein the planarization composition has a pH of about 1-5 to about 3, and
planarizing the substrate surface with the fixed abrasive article;
wherein the fixed abrasive article comprises a plurality of abrasive particles having a hardness of no greater than about 6.5 Mohs dispersed within a binder adhered to at least one surface of a backing material.

2. The method of claim 1 wherein the Group VIII metal-containing surface of the substrate has a nonplanar topography.

3. The method of claims 1 or 2 wherein the Group VIII metal-containing surface of the substrate comprises a Group VIII metal in elemental form or an alloy thereof.

4. The method of claim 3 wherein the Group VIII metal-containing surface comprises elemental platinum.

5. The method of claim 3 wherein the Group VIII metal-containing surface comprises a platinum alloy.

6. The method of any one of claims 1-5 wherein the Group VIII metal is present in an amount of about 10 atomic percent or more.

7. The method of claim 6 wherein the Group VIII metal is present in an amount of about 20 atomic percent or more,

8. The method of claim 7 wherein the Group VIII metal is present in an amount of about 50 atomic percent or more.

9. The method of any one of claims 1-8 wherein the substrate is a semiconductor substrate or substrate assembly.

10. The method of claim 9 wherein the substrate or substrate assembly comprises at least one region of a platinum-containing surface, and wherein planarizing comprises planarizing the at least one region of the platinum-containing surface with the fixed abrasive article.

11. The method of any one of claims 1-10 wherein the substrate is a wafer.

12. The method of claim 11 wherein the wafer has a patterned dielectric layer formed thereon and a Group VIII metal-containing layer formed over the patterned dielectric layer, wherein the planarization method is used in forming a capacitor or barrier layer.

13. The method of any one of claims 1-12 wherein the plurality of abrasive particles comprise CeO₂, Y₂O₃, Fe₂O₃, or mixtures thereof.

14. The method of claim 13 wherein a majority of the plurality of abrasive .. particles are CeO₂ abrasive particles.

15. The method of any one of claims 1-14 wherein the Group VIII metal-containing surface is removed relative to a dielectric layer at a selectivity ratio of at least about 10:1.

16. The method of claim 1 wherein the planarization composition comprises an oxidizing agent.

17. The method of claim 16 wherein the oxidizing agent is selected from the group consisting of ceric ammonium nitrate and ceric ammonium sulfate.

18. The method of any one of claims 1-17 wherein the planarization composition is an aqueous solution.

19. The method any one of claims 1-18 wherein the planarization composition comprises a surfactant, a thickener, a buffering agent or mixtures thereof.

## Patentansprüche

1. Planarisierungsverfahren, umfassend:
Positionieren einer ein Metall der Gruppe VIII enthaltenden Oberfläche eines Substrats an die Grenzfläche eines fixierten Schleifgegenstands, wobei das Metall der Gruppe VIII aus Rhodium, Iridium, Ruthenium, Osmium, Palladium, Platin und Kombinationen davon ausgewählt ist;
Zufuhr einer Planarisierungszusammensetzung nahe der Grenzfläche, wobei die Planarisierungszusammensetzung ein Oxidationsmittel, einen Komplexbildner oder
Gemische davon umfasst und wobei die Planarisierungszusammensetzung einen pH von etwa 1,5 bis etwa 3 aufweist; und
Planarisieren der Substratoberfläche mit dem fixierten Schleifgegenstand;
wobei der fixierte Schleifgegenstand eine Mehrzahl von Schleifteilchen mit einer Härte von nicht mehr als etwa 6,5 Mohs dispergiert in einem Bindemittel, das an mindestens einer Oberfläche eines Trägermaterials haftet, umfasst.

2. Verfahren nach Anspruch 1, wobei die ein Metall der Gruppe VIII enthaltende Oberfläche des Substrats eine nicht-planare Topographie aufweist.

3. Verfahren nach den Ansprüchen 1 oder 2, wobei die ein Metall der Gruppe VIII enthaltende Oberfläche des Substrats ein Metall der Gruppe VIII in elementarer Form oder eine Legierung davon umfasst.

4. Verfahren nach Anspruch 3, wobei die ein Metall der Gruppe VIII enthaltende Oberfläche elementares Platin umfasst.

5. Verfahren nach Anspruch 3, wobei die ein Metall der Gruppe VIII enthaltende Oberfläche eine Platinlegierung umfasst.

6. Verfahren nach einem der Ansprüche 1 bis 5, wobei das Metall der Gruppe VIII in einer Menge von etwa 10 Atomprozent oder mehr vorliegt.

7. Verfahren nach Anspruch 6, wobei das Metall der Gruppe VIII in einer Menge von etwa 20 Atomprozent oder mehr vorliegt.

8. Verfahren nach Anspruch 7, wobei das Metall der Gruppe VIII in einer Menge von etwa 50 Atomprozent oder mehr vorliegt.

9. Verfahren nach einem der Ansprüche 1 bis 8, wobei das Substrat ein Halbleitersubstrat oder eine Substratanordnung ist.

10. Verfahren nach Anspruch 9, wobei das Substrat oder die Substratanordnung mindestens einen Bereich einer Platin enthaltenden Oberfläche umfasst und wobei die Planarisierung das Planarisieren des mindestens einen Bereichs der Platin enthaltenden Oberfläche mit dem fixierten Schleifgegenstand umfasst.

11. Verfahren nach einem der Ansprüche 1 bis 10, wobei das Substrat ein Wafer ist.

12. Verfahren nach Anspruch 11, wobei der Wafer eine darauf gebildete dielektrische Leitungsmusterschicht und eine ein Metall der Gruppe VIII enthaltende Schicht, die über der dielektrischen Leitungsmusterschicht gebildet ist, aufweist, wobei das Planarisierungsverfahren bei der Herstellung eines Kondensators oder einer Sperrschicht verwendet wird.

13. Verfahren nach einem der Ansprüche 1 bis 12, wobei die Mehrzahl an Schleifteilchen CeO₂, Y₂O₃, Fe₂O₃ oder Gemische davon umfassen.

14. Verfahren nach Anspruch 13, wobei eine Mehrheit der Mehrzahl an Schleifteilchen CeO₂-Schleifteilchen sind.

15. Verfahren nach einem der Ansprüche 1 bis 14, wobei die ein Metall der Gruppe VIII enthaltende Oberfläche bezogen auf eine dielektrische Schicht in einem Selektivitätsverhältnis von mindestens etwa 10:1 entfernt wird.

16. Verfahren nach Anspruch 1, wobei die Planarisierungszusammensetzung ein Oxidationsmittel umfasst.

17. Verfahren nach Anspruch 16, wobei das Oxidationsmittel ausgewählt ist aus Cerammoniumnitrat und Cerammoniumsulfat.

18. Verfahren nach einem der Ansprüche 1 bis 17, wobei die Planarisierungszusammensetzung eine wässrige Lösung ist.

19. Verfahren nach einem der Ansprüche 1 bis 18, wobei die Planarisierungszusammensetzung ein grenzflächenaktives Mittel, ein Verdickungsmittel, einen Puffer oder Gemische davon umfasst.

## Revendications

1. Procédé de planarisation comprenant les étapes consistant à :
positionner une surface contenant un métal du groupe VIII d'un substrat sur l'interface d'un article abrasif fixe, dans lequel le métal du groupe VIII est choisi dans le groupe constitué par le rhodium, l'iridium, le ruthénium, l'osmium, le palladium, le platine et les combinaisons de ceux-ci ;
fournir une composition de planarisation à proximité de l'interface, dans lequel la composition de planarisation comprend un agent oxydant, un agent complexant ou des mélanges de ceux-ci et dans lequel la composition de planarisation a un pH d'environ 1,5 à environ 3 ; et
rendre plan la surface de substrat à l'aide de l'article abrasif fixe ;
dans lequel l'article abrasif fixe comprend une pluralité de particules abrasives ayant une dureté non supérieure à environ 6,5 Mohs dispersées au sein d'un liant mis à adhérer à au moins une surface d'un matériau de renfort.

2. Procédé selon la revendication 1, dans lequel la surface contenant un métal du groupe VIII du substrat a une topographie non plane.

3. Procédé selon la revendication 1 ou 2, dans lequel la surface contenant un métal du groupe VIII du substrat comprend un métal du groupe VIII sous forme élémentaire ou un alliage de celui-ci.

4. Procédé selon la revendication 3, dans lequel la surface contenant un métal du groupe VIII comprend du platine élémentaire.

5. Procédé selon la revendication 3, dans lequel la surface contenant un métal du groupe VIII comprend un alliage de platine.

6. Procédé selon l'une quelconque des revendications 1 à 5, dans lequel le métal du groupe VIII est présent en une quantité d'environ 10 % atomique ou plus.

7. Procédé selon la revendication 6, dans lequel le métal du groupe VIII est présent en une quantité d'environ 20 % atomique ou plus.

8. Procédé selon la revendication 7, dans lequel le métal du groupe VIII est présent en une quantité d'environ 50 % atomique ou plus.

9. Procédé selon l'une quelconque des revendications 1 à 8, dans lequel le substrat est un substrat semi-conducteur ou un ensemble de substrat.

10. Procédé selon la revendication 9, dans lequel le substrat ou l'ensemble de substrat comprend au moins une région d'une surface contenant du platine, et dans lequel la planarisation comprend la planarisation de l'au moins une région de la surface contenant du platine à l'aide de l'article abrasif fixe.

11. Procédé selon l'une quelconque des revendications 1 à 10, dans lequel le substrat est une tranche.

12. Procédé selon la revendication 11, dans lequel la tranche a une couche diélectrique formée en motif formée dessus et une couche contenant un métal du groupe VIII formée sur la couche diélectrique formée en motif, dans lequel le procédé de planarisation est utilisé dans la formation d'un condensateur ou d'une couche barrière.

13. Procédé selon l'une quelconque des revendications 1 à 12, dans lequel la pluralité de particules abrasives comprend du CeO₂, du Y₂O₃, du Fe₂O₃ ou des mélanges de ceux-ci.

14. Procédé selon la revendication 13, dans lequel une majorité de la pluralité de particules abrasives sont des particules abrasives de CeO₂.

15. Procédé selon l'une quelconque des revendications 1 à 14, dans lequel la surface contenant un métal du groupe VIII est retirée par rapport à une couche diélectrique à un rapport de sélectivité d'au moins environ 10 : 1.

16. Procédé selon la revendication 1, dans lequel la composition de planarisation comprend un agent oxydant.

17. Procédé selon la revendication 16, dans lequel l'agent oxydant est choisi dans le groupe constitué par le nitrate d'ammonium cérique et le sulfate d'ammonium cérique.

18. Procédé selon l'une quelconque des revendications 1 à 17, dans lequel la composition de planarisation est une solution aqueuse.

19. Procédé selon l'une quelconque des revendications 1 à 18, dans lequel la composition de planarisation comprend un agent tensioactif, un épaississant, un agent tampon ou des mélanges de ceux-ci.
